# EUROPEAN PATENT APPLICATION

(11) **EP 4 629 122 A1**
(43) Date of publication of application: **08.10.2025**
(21) Application number: 23916394.2
(22) Date of filing: 10.11.2023
(51) Int. Cl.: G06F 30/13, G06F 30/12, G06T 7/10, G06T 7/62

(54) **DATA PROCESSING METHOD AND DEVICE FOR RECREATING FLOOR PLAN IMAGE**

(30) Priority: 09.01.2023 KR 20230003032
(71) Applicant: Samsung Electronics Co., Ltd., Suwon-si, Gyeonggi-do 16677 (KR)
(72) Inventor: PARK, Junseong, Suwon-si, Gyeonggi-do 16677 (KR); KIM, Dowan, Suwon-si, Gyeonggi-do 16677 (KR); KIM, Soyoung, Suwon-si, Gyeonggi-do 16677 (KR); PARK, Sijun, Suwon-si, Gyeonggi-do 16677 (KR); JUNG, Heerok, Suwon-si, Gyeonggi-do 16677 (KR); HWANGBO, Hoon, Suwon-si, Gyeonggi-do 16677 (KR)
(74) Representative: Arnold & Siedsma
(86) International application number: PCT/KR2023/018064
(87) International publication number: WO 2024/150911

(57) **Abstract**

Provided is a data processing method including obtaining, from an obtained floor plan image, at least one guide line and an actually-measured length corresponding to each of the at least one guide line, splitting the floor plan image into at least one section, based on a line extending from a scale of the at least one guide line, determining, as an adjustable space, a section in which both actually-measured lengths respectively corresponding to a width and a height exist, among the at least one section, adjusting a ratio of a greatest horizontal length and a greatest vertical length of the floor plan image, according to a ratio of a greatest actually-measured length corresponding to a width of the floor plan image and a greatest actually-measured length corresponding to a height of the floor plan image, and adjusting a horizontal length and a vertical length of the adjustable space according to ratios of the greatest actually-measured lengths respectively corresponding to the width and height of the floor plan image and actually-measured lengths respectively corresponding to a width and a height of the adjustable space.

## Description

### Technical Field

Various embodiments relate to a data processing method and device for regenerating a floor plan image according to a ratio of actually-measured length information written on the floor plan image.

### Background Art

Floor plans are drawings showing a plan of a building, etc., and are views from above where a building is cut horizontally to show the rooms, entrances, windows, etc. located on each floor of the building.

Because a floor plan is a drawing that is a scaled-down version of an actual size, the actual size is indicated on the drawing. However, because the actual size and the size drawn on a floor plan image are not always drawn to be strictly consistent with each other in a proportional manner, there may be limitations in its use.

### Disclosure of Invention

### Solution to Problem

A data processing method of regenerating a floor plan image, according to an embodiment, may include obtaining the floor plan image. The data processing method of regenerating a floor plan image, according to an embodiment, may include obtaining at least one guide line and an actually-measured length corresponding to each of the at least one guide line from the obtained floor plan image. The data processing method of regenerating a floor plan image, according to an embodiment, may include splitting the floor plan image into at least one section, based on a line extending from a scale of the at least one guide line. The data processing method of regenerating a floor plan image, according to an embodiment, may include determining, as an adjustable space, a section in which both actually-measured lengths respectively corresponding to a width and a height exist, among the at least one section. The data processing method of regenerating a floor plan image, according to an embodiment, may include adjusting a ratio of a greatest horizontal length and a greatest vertical length of the floor plan image, according to a ratio of a greatest actually-measured length corresponding to a width of the floor plan image and a greatest actually-measured length corresponding to a height of the floor plan image. The data processing method of regenerating a floor plan image, according to an embodiment, may include adjusting a horizontal length of the adjustable space according to a ratio of the greatest actually-measured length corresponding to the width of the floor plan image and an actually-measured length corresponding to a width of the adjustable space, and adjusting a vertical length of the adjustable space according to a ratio of the greatest actually-measured length corresponding to the height of the floor plan image and an actually-measured length corresponding to a height of the adjustable space. The data processing method of regenerating a floor plan image, according to an embodiment, may include displaying an adjusted floor plan image.

According to an embodiment, a data processing device for regenerating a floor plan image may include a memory storing one or more instructions. A data processing device for regenerating a floor plan image, according to an embodiment, may include at least one processor. The at least one processor may be configured to execute the one or more instructions stored in the memory to obtain a floor plan image. The at least one processor may be configured to execute the one or more instructions stored in the memory to obtain at least one guide line and an actually-measured length corresponding to each of the at least one guide line from the obtained floor plan image. The at least one processor may be configured to execute the one or more instructions stored in the memory to split the floor plan image into at least one section, based on a line extending from a boundary of the at least one guide line. The at least one processor may be configured to execute the one or more instructions stored in the memory to determine, as an adjustable space, a section in which both actually-measured lengths respectively corresponding to a width and a height exist, among the at least one section. The at least one processor may be configured to execute the one or more instructions stored in the memory to adjust a ratio of a greatest horizontal length and a greatest vertical length of the floor plan image, according to a ratio of a greatest actually-measured length corresponding to a width of the floor plan image and a greatest actually-measured length corresponding to a height of the floor plan image. The at least one processor may be configured to execute the one or more instructions stored in the memory to adjust a horizontal length of the adjustable space according to a ratio of the greatest actually-measured length corresponding to the width of the floor plan image and an actually-measured length corresponding to a width of the adjustable space, and adjust a vertical length of the adjustable space according to a ratio of the greatest actually-measured length corresponding to the height of the floor plan image and an actually-measured length corresponding to a height of the adjustable space. The at least one processor may be configured to execute the one or more instructions stored in the memory to display an adjusted floor plan image.

A computer-readable recording medium according to an embodiment may be a recording medium having recorded thereon a program for implementing a data processing method of regenerating a floor plan image, the data processing method including obtaining the floor plan image. A computer-readable recording medium according to an embodiment may be a recording medium having recorded thereon a program for implementing a data processing method of regenerating a floor plan image, the data processing method including obtaining at least one guide line and an actually-measured length corresponding to each of the at least one guide line from the obtained floor plan image. A computer-readable recording medium according to an embodiment may be a recording medium having recorded thereon a program for implementing a data processing method of regenerating a floor plan image, the data processing method including splitting the floor plan image into at least one section, based on a line extending from a scale of the at least one guide line. A computer-readable recording medium according to an embodiment may be a recording medium having recorded thereon a program for implementing a data processing method of regenerating a floor plan image, the data processing method including determining, as an adjustable space, a section in which both actually-measured lengths respectively corresponding to a width and a height exist, among the at least one section. A computer-readable recording medium according to an embodiment may be a recording medium having recorded thereon a program for implementing a data processing method of regenerating a floor plan image, the data processing method including adjusting a ratio of a greatest horizontal length and a greatest vertical length of the floor plan image, according to a ratio of a greatest actually-measured length corresponding to a width of the floor plan image and a greatest actually-measured length corresponding to a height of the floor plan image. A computer-readable recording medium according to an embodiment may be a recording medium having recorded thereon a program for implementing a data processing method of regenerating a floor plan image, the data processing method including adjusting a horizontal length of the adjustable space according to a ratio of the greatest actually-measured length corresponding to the width of the floor plan image and an actually-measured length corresponding to a width of the adjustable space, and adjusting a vertical length of the adjustable space according to a ratio of the greatest actually-measured length corresponding to the height of the floor plan image and an actually-measured length corresponding to a height of the adjustable space. A computer-readable recording medium according to an embodiment may be a recording medium having recorded thereon a program for implementing a data processing method of regenerating a floor plan image, the data processing method including displaying the adjusted floor plan image.

### Brief Description of Drawings

FIG. 1 is a drawing showing an example of regenerating a floor plan image, according to an embodiment of the present disclosure.
FIG. 2 is a drawing showing an example of a guide line of a floor plan image and an actually-measured length corresponding to the guide line, according to an embodiment of the present disclosure.
FIG. 3 is a block diagram of a structure of a data processing device for regenerating a floor plan image, according to an embodiment of the present disclosure.
FIG. 4 is a flowchart of a data processing method of regenerating a floor plan image, according to an embodiment of the present disclosure.
FIG. 5 is a flowchart of a data processing method of regenerating a floor plan image, according to an embodiment of the present disclosure.
FIG. 6 is a drawing illustrating an example in which a data processing device for regenerating a floor plan image obtains a guide line and an actually-measured length corresponding to the guide line from the floor plan image, according to an embodiment of the present disclosure.
FIG. 7 is a drawing illustrating an example in which a data processing device for regenerating a floor plan image obtains information about space division from the floor plan image, according to an embodiment of the present disclosure.
FIG. 8 is a drawing illustrating an example in which a data processing device for regenerating a floor plan image splits a floor plan image into at least one section, based on a line extending from the scale of at least one guide line, according to an embodiment of the present disclosure.
FIG. 9 is a drawing illustrating an example in which a data processing device for regenerating a floor plan image configures a vertex point and determines a section according to the vertex point, according to an embodiment of the present disclosure.
FIG. 10 is a drawing illustrating an example in which a data processing device for regenerating a floor plan image determines, as an adjustable space, a section in which both actually-measured lengths respectively corresponding to a width and a height exist, according to an embodiment of the present disclosure.
FIG. 11 is a drawing illustrating an example in which a data processing device for regenerating a floor plan image changes a combined section corresponding to a combination of peripheral sections to an adjustable space, according to an embodiment of the present disclosure.
FIG. 12 is a drawing illustrating an example of a result of changing a combined section corresponding to a combination of peripheral sections to an adjustable space by a data processing device for regenerating a floor plan image, according to an embodiment of the present disclosure.
FIG. 13 is a drawing illustrating an example in which a data processing device for regenerating a floor plan image adjusts a ratio between a width and a height of the entire drawing, according to an embodiment of the present disclosure.
FIG. 14 is a drawing illustrating an example in which a data processing device for regenerating a floor plan image adjusts a ratio between a width and a height of each adjustable space, according to an embodiment of the present disclosure.

### Mode for Invention

Embodiments of the present disclosure are described in detail herein with reference to the accompanying drawings so that the present disclosure may be easily performed by one of ordinary skill in the art to which the present disclosure pertains. The present disclosure may, however, be embodied in many different forms and should not be construed as being limited to the examples set forth herein.

Although general terms widely used at present were selected for describing the disclosure in consideration of the functions thereof, these general terms may vary according to intentions of one of ordinary skill in the art, case precedents, the advent of new technologies, or the like. Hence, the terms must be defined based on their meanings and the contents of the entire specification, not by simply stating the terms.

The terms used in the present disclosure are merely used to describe particular embodiments, and are not intended to limit the scope of the present disclosure.

Throughout the specification, when an element is referred to as being "connected" or "coupled" to another element, it can be directly connected or coupled to the other element, or can be electrically connected or coupled to the other element with intervening elements interposed therebetween.

The use of the terms "a" and "an" and "the" and similar referents in the context of describing the disclosure (especially in the context of the following claims) are to be construed to cover both the singular and the plural. Also, the steps of all methods described herein can be performed in any suitable order unless otherwise indicated herein or otherwise clearly contradicted by context. Embodiments of the disclosure are not limited to the described order of the operations.

Thus, the expression "according to an embodiment" used in the entire disclosure does not necessarily indicate the same embodiment.

Embodiments of the disclosure may be described in terms of functional block components and various processing steps. Some or all of these functional blocks may be implemented using various numbers of hardware and/or software configurations that perform specific functions. For example, the functional blocks of the disclosure may be implemented by one or more microprocessors, or by circuit configurations for a certain function. For example, the functional blocks of the disclosure may be implemented in various programming or scripting languages. The functional blocks may be implemented as algorithms executed in one or more processors. The disclosure may employ the conventional art for electronic configuration, signal processing, and/or data processing, for example. The words "mechanism," "element," "means," and "configuration" are used broadly and are not limited to mechanical or physical embodiments,

Furthermore, the connecting lines or connectors between components shown in the various figures presented are intended to represent exemplary functional relationships and/or physical or logical couplings between the components. In an actual device, a connection between components may be represented by various functional connections, physical connections, or circuit connections that are replaceable or added.

The terms "unit", "-er (-or)", and "module" when used in this specification refers to a unit in which at least one function or operation is performed, and may be implemented as hardware, software, or a combination of hardware and software.

Embodiments of the present disclosure will now be described more fully with reference to the accompanying drawings.

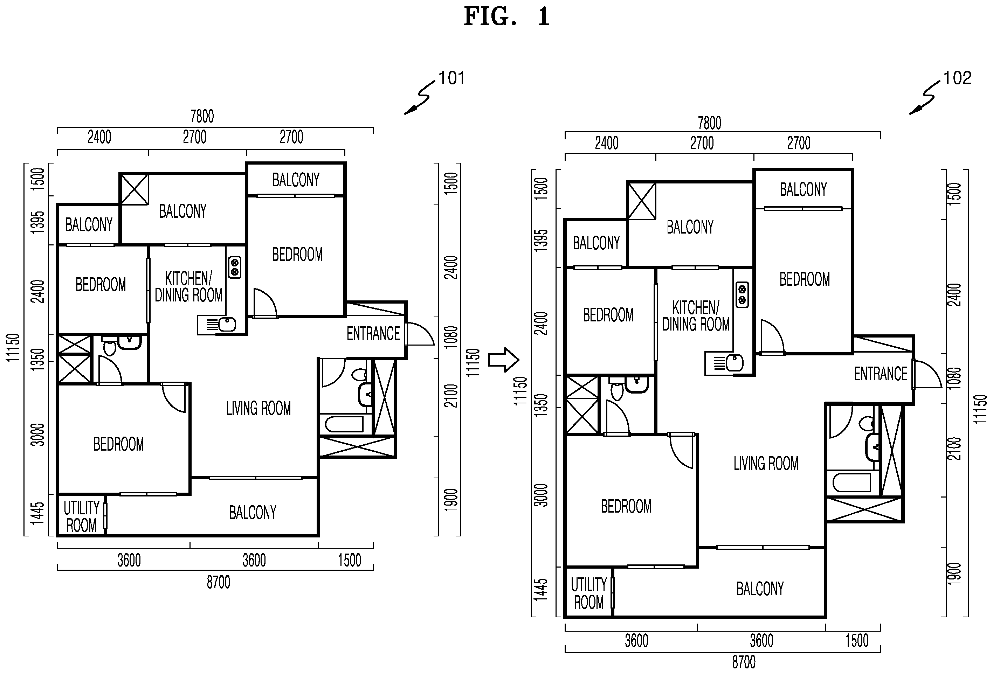

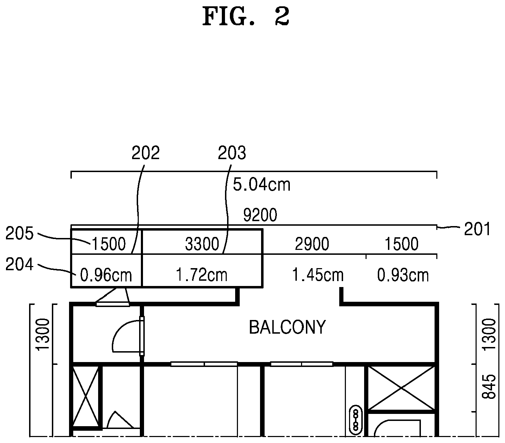

FIG. 1 is a drawing showing an example of regenerating a floor plan image, according to an embodiment of the present disclosure, and FIG. 2 is a drawing showing an example of a guide line of a floor plan image and an actually-measured length corresponding to the guide line, according to an embodiment of the present disclosure.

According to an embodiment, a data processing device 100 for regenerating a floor plan image may regenerate a floor plan image as in FIG. 1 by addressing a problem illustrated in FIG. 2.

According to an embodiment, the data processing device 100 for regenerating a floor plan image may regenerate a floor plan image as in FIG. 1 in order to address the problem illustrated in FIG. 2.

In the embodiment of FIG. 1, the data processing device 100 regenerating the floor plan image may regenerate a floor plan image 102 on the right side by adjusting a floor plan image 101 on the left side by reflecting actually-measured length information described in the floor plan image.

In the embodiment of FIG. 1, the regenerated floor plan image 102 on the right side may be a floor plan image whose horizontal length is the same and whose vertical length is extended overall when compared to the floor plan image 101 on the left side.

The floor plan image of the present disclosure may include at least one guide line and actually-measured length information corresponding to each of the at least one guide line.

In the present disclosure, a "guide line" is a line disposed to indicate length information of each space included in a floor plan image, and may include a scale to indicate what range of length the length information refers to. According to an embodiment, the floor plan image may include at least one guide line. According to an embodiment, the at least one guide line may be disposed at an edge of the floor plan image.

In the present disclosure, "actually-measured length information corresponding to a guide line" has the same meaning as an actually-measured length corresponding to the guide line, and thus may refer to length information of an actual space corresponding to a space indicated by a guide line divided by a scale. The actually-measured length corresponding to the guide line may be expressed in numbers.

According to an embodiment, the actually-measured length corresponding to the guide line may be information unified into one of the units of length, such as a centimeter (CM), an inch (in), or a millimeter (MM). In this case, a unit in a floor plan view may be omitted. The actually-measured length corresponding to the guide line refers to the actually-measured length of the actual space, and is different from a length of the guide line, which refers to a length of the guide line itself drawn on the floor plan image.

FIG. 2 is a drawing showing an example of a guide line of a floor plan image and an actually-measured length corresponding to the guide line, according to an embodiment of the present disclosure.

In the embodiment of FIG. 2, a first guide line 202 may include a scale 201 to indicate where the length information starts and ends. The first guide line 202 may include the scale 201 at each of a start and an end of the guide line.

According to an embodiment, an actually-measured length 203 corresponding to the guide line means actually-measured length information of a space corresponding to the guide line, and may be described in a direction perpendicular to the scale at a location closest in a direction from the guide line to the edge of the floor plan image.

In the embodiment of FIG. 2, text 9200 may be an actually-measured length corresponding to a guide line closest in a direction from the text 9200 to a center of the floor plan image, that is, a guide line indicating the entire horizontal length of the floor plan image. That is, the text 9200 may refer to a greatest actually-measured length in a horizontal direction of the building indicated by the floor plan image of FIG. 2.

In addition, text 1500 205 may be an actually-measured length corresponding to a guide line closest in a direction from the text 1500 205 to the center of the floor plan image, that is, to a portion of the left side of a balcony. In this case, the guide line closest in a direction toward the center of the floor plan image may refer to a guide line upto the left and right scales 201.

In the embodiment of FIG. 2, an actually-measured length corresponding to the first guide line 202 may be 1500, and an actually-measured length corresponding to a second guide line 203 may be 3300.

However, a length of the first guide line 202 on the floor plan image may be 0.96 cm, and a length of the second guide line 203 may be 1.72 cm.

At this time, a ratio of the actually-measured lengths respectively corresponding to the first guide line 202 and the second guide line 203 may be 1500 to 3300, i.e. 0.96 to 2.11, whereas a ratio of the length of the first guide line 202 to the length of the second guide line 203 may be 0.96 to 1.72.

In this case, a discrepancy may occur between the ratio of the length of the first guide line 202 to the length of the second guide line 203, which is 0.96 to 1.72, and the ratio of the actually-measured lengths respectively corresponding to the first guide line 202 and the second guide line 203, which is 0.96 to 2.11.

When there is an error in a ratio of an actually-measured length described in a floor plan image, i.e., length information, to a length of the floor plan image as described above, there may be difficulties in utilizing the floor plan image.

According to an embodiment, when there is an error in the ratio of the described actually-measured length, i.e., the length information, to the length of the floor plan image, a data processing device 100 regenerating a floor plan image may regenerate a floor plan image that is proportionally identical to the actually-measured length information, by, as in the embodiment of FIG. 1, maintaining a horizontal length in the floor plan image 101 on the left side, which is the original version, and adjusting a vertical length therein by entirely expanding or reducing the vertical length.

In the embodiment of FIG. 2, the data processing device 100 regenerating a floor plan image may be a desktop computer. However, this is merely an embodiment, and the data processing device 100 may be implemented in any of various types.

For example, the data processing device 100 regenerating a floor plan image may be implemented in various forms, such as a tablet PC, a digital camera, a camcorder, a laptop computer, a netbook computer, a desktop computer, an e-book terminal, a video phone, a digital broadcast terminal, PDAs, a PMP, a navigation device, a wearable device, a smart refrigerator, and other home appliances.

The data processing device 100 regenerating a floor plan image may be any of various types of information processing devices including processors.

In a method of adjusting a floor plan image according to a ratio of the described actually-measured lengths by using an information processing device for regenerating a floor plan image, a floor plan image not conforming to the ratio of actually-measured lengths is immediately regenerated into an image conforming to the ratio of actually-measured lengths without time-consuming or cumbersome works, so that the usability of a floor plan may be increased when a user arranges furniture or predicts a space.

For example, when furniture arrangement is simulated in a virtual space, the virtual space may be created based on a floor plan image regenerated in accordance with an actually-measured image ratio.

Because users typically want to simulate the layout of furniture or space in a virtual space while shopping for furniture or interior accessories, it may be meaningless if the regenerated floor plan is not immediately available. Therefore, a technology capable of immediately regenerating a floor plan by using the information processing device 100 may be significant, separate from a user generating a floor plan manually.

A detailed method, performed by the data processing device 100 regenerating a floor plan image, of regenerating a floor plan image will be described later.

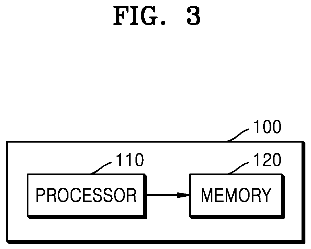

FIG. 3 is a block diagram of a structure of a data processing device regenerating a floor plan image, according to an embodiment of the present disclosure.

Referring to FIG. 3, the data processing device 100 regenerating a floor plan image may include a processor 110 and a memory 120.

The memory 120 may store a program for processing and controlling by the processor 110. The memory 120 may store data that is input to the data processing device 100 regenerating a floor plan image or output by the data processing device 100 regenerating a floor plan image.

The memory 120 may include at least one selected from an internal memory (not shown) and an external memory (not shown). The memory 120 may store control history information, current environment information, and status information.

The memory 120 may include at least one type of storage medium selected from among a flash memory type, a hard disk type, a multimedia card micro type, a card type memory (for example, a secure digital (SD) or extreme digital (XD) memory), a random access memory (RAM), a static random access memory (SRAM), a read-only memory (ROM), an electrically erasable programmable ROM (EEPROM), a programmable ROM (PROM), magnetic memory, a magnetic disk, and an optical disk.

The internal memory may include, for example, at least one selected from volatile memory (for example, dynamic RAM (DRAM), static RAM (SRAM), or synchronous dynamic RAM (SDRAM)), non-volatile memory (for example, one time programmable ROM (OTPROM), programmable ROM (PROM), erasable and programmable ROM (EPROM), electrically erasable and programmable ROM (EEPROM), mask ROM, or flash ROM), a hard disk drive (HDD), and a solid state drive (SSD).

According to an embodiment of the disclosure, the processor 110 may load a command or data received from at least one of the non-volatile memory or another element into the volatile memory and process the command or the data. The processor 110 may store data received or generated from another element in the non-volatile memory.

The external memory may include, for example, at least one selected from Compact Flash (CF), Secure Digital (SD), Micro-SD, Mini-SD, extreme Digital (xD) and Memory Stick.

The memory 120 may store one or more instructions executable by the processor 110.

According to an embodiment, the memory 120 may store various types of information than are received through an input/output interface (not shown).

According to an embodiment, the memory 120 may store instructions for controlling a processor to obtain a floor plan image, obtain at least one guide line and an actually-measured length corresponding to each of the at least one guide line from the obtained plan view image, divide the floor plan image into at least one section by a line extending from a scale of the at least one guide line, determine a section in which both actually-measured lengths corresponding to a width and a height exist, among the at least one section, as an adjustable space, adjust a ratio of a greatest horizontal length and a greatest vertical length of the floor plan image according to a ratio of a greatest actually-measured length corresponding to the width of the floor plan image and a greatest actually-measured length corresponding to the height of the floor plan image, adjust a horizontal length of the adjustable space according to a ratio of the greatest actually-measured length corresponding to the width of the floor plan image and an actually-measured length corresponding to the width of the adjustable space, and adjust a vertical length of the adjustable space according to a ratio of the greatest actually-measured length corresponding to the height of the floor plan image and an actually-measured length corresponding to the height of the adjustable space.

When there is an input of a user or stored preset conditions are satisfied, the processor 110 may execute an operating system (OS) and various applications that are stored in the memory 120.

The processor 110 may include a RAM that stores a signal or data received from the outside of the data processing device 100 regenerating a floor plan image or is used as a storage area for various operations performed by the data processing device 100 regenerating a floor plan image, and a ROM that stores a control program for controlling the data processing device 100 regenerating a floor plan image.

The processor 110 may include a single core, a dual core, a triple core, a quad core, or a multiple core thereof. The processor 110 may include a plurality of processors. For example, the processor 110 may be implemented by using a main processor and a sub-processor operating in a sleep mode.

The processor 110 may include at least one of a central processing unit (CPU), a graphics processing unit (GPU), or a video processing unit (VPU). Alternatively, according to embodiments, the processor 110 may be implemented in the form of a system on chip (SOC) that integrates at least one of a CPU, a GPU, or a VPU.

The processor 110 may control the components of the data processing device 100 regenerating various floor plan images by executing the one or more programs stored in the memory 120.

According to an embodiment, the display 110 may obtain a floor plan image.

According to an embodiment, the processor 110 may obtain at least one guide line and an actually-measured length corresponding to each of the at least one guide line from the obtained floor plan image.

According to an embodiment, the actually-measured length corresponding to the at least one guide line may be obtained by detecting text information corresponding to the at least one guide line from the floor plan image and matching the detected text information with the actually-measured length corresponding to the at least one guide line. A method of matching the detected text information with the actually-measured length corresponding to the at least one guide line will be described later in detail.

According to an embodiment, the processor 110 may divide the floor plan image into at least one section by a line extending from a scale of the at least one guide line.

According to an embodiment, the processor 110 may determine a section in which both actually-measured lengths respectively corresponding to a width and a height exist, among the at least one section, as an adjustable space.

According to an embodiment, the processor 110 may adjust a ratio of a greatest horizontal length and a greatest vertical length of the floor plan image according to a ratio of a greatest actually-measured length corresponding to the width of the floor plan image and a greatest actually-measured length corresponding to the height of the floor plan image, adjust a horizontal length of the adjustable space according to a ratio of the greatest actually-measured length corresponding to the width of the floor plan image and an actually-measured length corresponding to the width of the adjustable space, and adjust a vertical length of the adjustable space according to a ratio of the greatest actually-measured length corresponding to the height of the floor plan image and an actually-measured length corresponding to the height of the adjustable space.

According to an embodiment, the processor 110 may adjust an overall vertical length of the floor plan image based on an overall horizontal length of the floor plan image, according to a ratio of an actually-measured length corresponding to the entire width of the floor plan image and an actually-measured length corresponding to the entire height of the floor plan image.

According to an embodiment, the processor 110 may determine, as a vertex point, a location where lines extending from the at least one guide line intersect each other, and may determine a rectangular area including four vertex points as one section.

According to an embodiment, the processor 110 may adjust an X-axis location or a Y-axis location of a vertex point included in an area indicating the entire floor plan image, according to a ratio of a greatest actually-measured length corresponding to the width of the floor plan image and a greatest actually-measured length corresponding to the height of the floor plan image, thereby adjusting the ratio of the greatest horizontal length and the greatest vertical length of the floor plan image.

According to an embodiment, the processor 110 may adjust an X-axis location of a vertex point included in the adjustable space, according to a ratio of the greatest actually-measured length corresponding to the width of the floor plan image and an actually-measured length corresponding to a width of the adjustable space.

According to an embodiment, the processor 110 may adjust an Y-axis location of the vertex point included in the adjustable space, according to a ratio of the greatest actually-measured length corresponding to the height of the floor plan image and an actually-measured length corresponding to a height of the adjustable space.

According to an embodiment, the processor 110 may obtain information about space division, including a line representing at least one of a wall, a door, and a window and a name of a space formed by the line, from the obtained floor plan image, and rearrange the information about the space division according to a result of the adjustment.

According to an embodiment, the processor 110 may rearrange a guide line and an actually-measured length corresponding to the guide line from the result of the adjustment.

The block diagram of the data processing device 100 regenerating a floor plan image, shown in FIG. 3, is for an embodiment. Components of the block diagram may be combined or omitted according to the specifications of the data processing device 100 regenerating a floor plan image when being actually implemented, or additional components may be included in the data processing device 100 regenerating a floor plan image. **In** other words, two or more components may be combined into a single component, or a single component may be divided into two or more components. A function performed in each block is merely an example to explain embodiments, and a detailed operation or device of each block does not limit the scope of the embodiments.

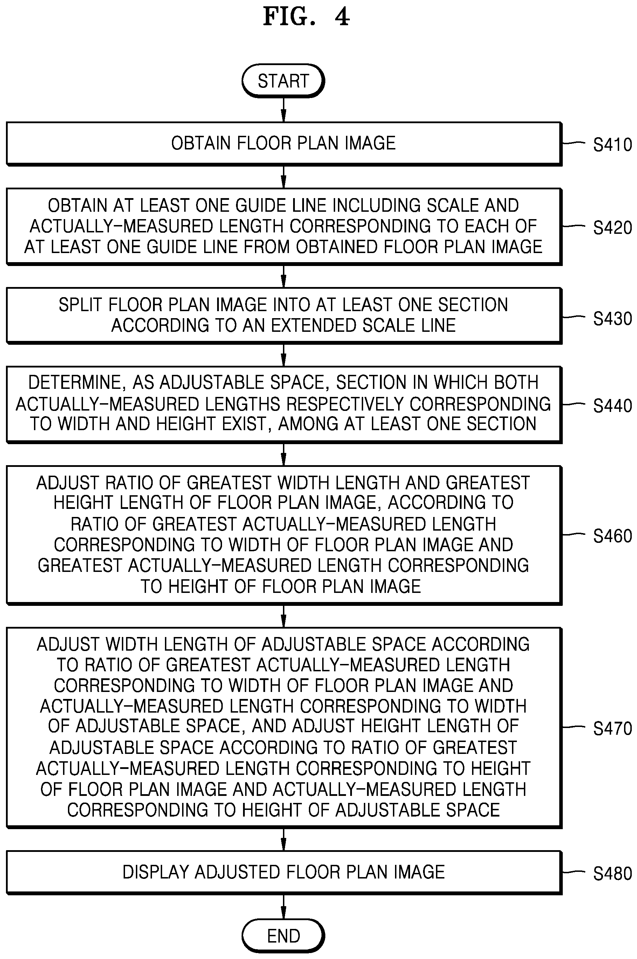

FIG. 4 is a flowchart of a data processing method of regenerating a floor plan image, according to an embodiment of the present disclosure.

Referring to FIG. 4, the data processing device 100 regenerating a floor plan image may obtain a floor plan image (S410).

According to an embodiment, the data processing device 100 regenerating a floor plan image may obtain the floor plan image from an external device.

According to an embodiment, the data processing device 100 for regenerating a floor plan image may obtain the floor plan image by directly drawing a floor plan by using an image sensor or by scanning a document on which the floor plan is printed.

The data processing device 100 regenerating a floor plan image may obtain the floor plan image according to various other methods.

The data processing device 100 regenerating a floor plan image may obtain at least one guide line including a scale and an actually-measured length corresponding to each of the at least one guide line from the obtained floor plan image (S420).

According to an embodiment, the data processing device 100 regenerating a floor plan image may extract a guide line from the floor plan image through a known algorithm, such as CV corner detection.

According to an embodiment, the data processing device 100 regenerating a floor plan image may extract a guide line from the floor plan image by using an artificial intelligence (AI) model.

According to an embodiment, the data processing device 100 regenerating a floor plan image may identify the guide line and a line other than the guide line according to various ways.

According to an embodiment, the data processing device 100 regenerating a floor plan image may extract text from the floor plan image through a known algorithm, such as OCR (RCNN-resnet). The extracted text may include actually-measured length information corresponding to each guide line.

According to an embodiment, the data processing device 100 regenerating a floor plan image may identify text corresponding to actually-measured length information corresponding to the guide line and text not corresponding to the actually-measured length information corresponding to the guide line according to various methods.

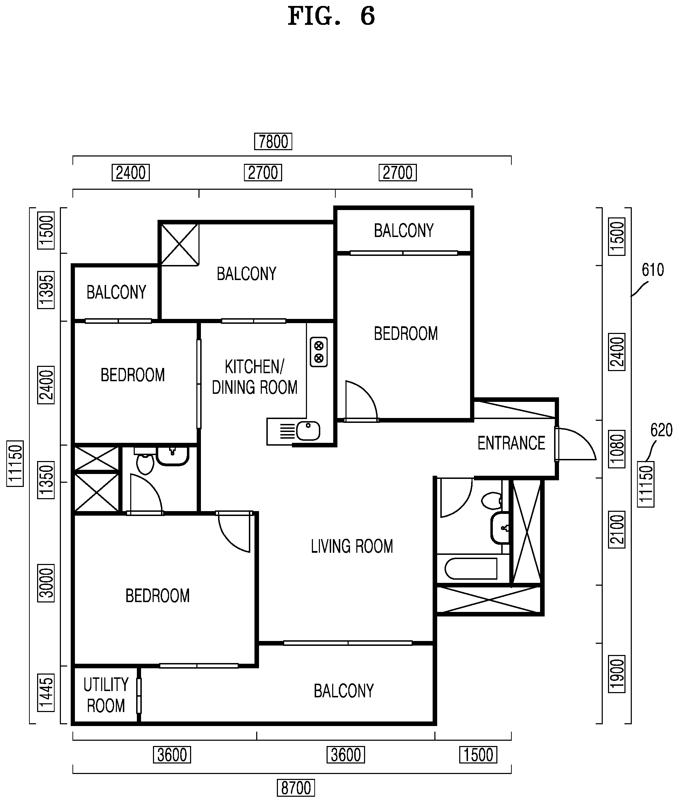

This will be described in detail later with reference to FIG. 6.

The data processing device 100 regenerating a floor plan image may split the floor plan image into at least one section according to an extended scale line (S430).

According to an embodiment, the data processing device 100 regenerating a floor plan image may expand all scale lines included in the obtained at least one guide line.

The floor plan image may be split into the at least one section by extended scale lines.

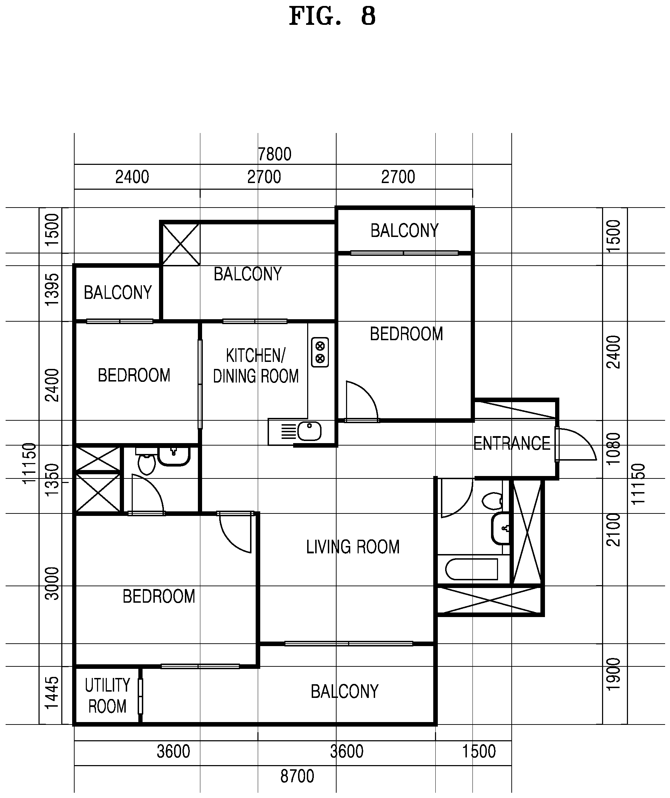

This will be described in detail later with reference to FIG. 8.

The data processing device 100 regenerating a floor plan image may determine a section in which both actually-measured lengths respectively corresponding to a width and a height exist, among the at least one section, as an adjustable space (S440).

According to an embodiment, the data processing device 100 regenerating a floor plan image may identify a section in which all of the actually-measured length information corresponding to a width and height of the section exists by referring to the guide line and the scale included in the guide line, from among the at least one section.

According to an embodiment, the data processing device 100 regenerating a floor plan image may determine the adjustable space only for the interior space of a building on the floor plan image, from among the split sections.

According to an embodiment, the data processing device 100 regenerating a floor plan image may determine the adjustable space, based on a space formed by a line indicating at least one of a wall, a door, and a window on the floor plan image, from the identified section.

According to an embodiment, the data processing device 100 regenerating a floor plan image may obtain information about the line indicating at least one of a wall, a door, and a window on the floor plan image and the space formed by the line, when analyzing the floor plan image.

According to an embodiment, the determined adjustable space may be the space formed by the line indicating at least one of a wall, a door, and a window from the building's interior space on the floor plan image, or may be a space obtained by combining the line indicating at least one of a wall, a door, and a window from the building's interior space on the floor plan image with some of its peripheral sections.

According to an embodiment, the data processing device 100 regenerating a floor plan image may first determine, as the adjustable space, a space in which both pieces of actually-measured length information respectively corresponding to the width and the height exist according to whether both the pieces of actually-measured length information respectively corresponding to the width and the height exist, while traveling through the space formed by the line indicating at least one of a wall, a door, and a window on the floor plan image.

According to an embodiment, the data processing device 100 regenerating a floor plan image may combine a section including a space not determined as the adjustable space among the space formed by the line indicating at least one of a wall, a door, and a window within the building's interior space on the floor plan image with a peripheral section, and thus determine a combined section as the adjustable space when both the pieces of actually-measured length information respectively corresponding to the width and the height exist.

In other words, the data processing device 100 regenerating a floor plan image may determine the adjustable space in a similar order to the space formed by the line indicating at least one of a wall, a door, and a window on the floor plan image.

According to an embodiment, when a certain section is combined with a peripheral section and a plurality of peripheral sections in which both the pieces of actually-measured length information respectively corresponding to the width and the height exist, the data processing device 100 regenerating a floor plan image may determine the peripheral section that is to be combined with a combined section in a similar order to the space formed by the line indicating at least one of a wall, a door, and a window on the floor plan image.

In this case, whether both the actually-measured length information of the width and the actually-measured length information of the height exist in a certain section may mean whether there exists an actually-measured length corresponding to a horizontal guide line in the section and an actually-measured length corresponding to a vertical guide line.

In the present disclosure, the "adjustable space" may refer to a section in which both pieces of actually-measured length information corresponding to the width and the height exist based on the space formed by the line indicating at least one of a wall, a door, and a window in the building's interior space on the floor plan image and a length of the space drawn on the floor plan image is adjustable based on the pieces of actually-measured length information.

According to an embodiment, the data processing device 100 regenerating a floor plan image may delete all sections within the space determined as the adjustable space.

According to an embodiment of the disclosure, determined adjustable spaces may not overlap each other.

The data processing device 100 may adjust a length drawn according to a ratio of actually-measured lengths for the entire floor plan image by enabling all sections to be determined as adjustable spaces.

The data processing device 100 regenerating a floor plan image may adjust the ratio of the greatest horizontal length and the greatest vertical length of the floor plan image, according to the ratio of the greatest actually-measured length corresponding to the width of the floor plan image and the greatest actually-measured length corresponding to the height of the floor plan image (S460).

The greatest actually-measured length corresponding to the width of the floor plan image and the greatest actually-measured length corresponding to the height of the floor plan image may be actually-measured length information described on the floor plan image.

According to an embodiment, the data processing device 100 may first adjust the ratio of the overall horizontal length of the floor plan image and the overall vertical length of the floor plan image in order to regenerate the floor plan image according to the ratio of actually-measured lengths.

According to an embodiment, the data processing device 100 may adjust a greatest vertical length of the floor plan image based on a greatest horizontal length of the floor plan image, according to the ratio of the greatest actually-measured length corresponding to the width of the floor plan image and the greatest actually-measured length corresponding to the height of the floor plan image. That is, the data processing device 100 may regenerate the floor plan image according to the actually-measured length ratio by adjusting the greatest vertical length, while maintaining the greatest horizontal length without changes.

According to an embodiment, the data processing device 100 may adjust a greatest horizontal length of the floor plan image based on a greatest vertical length of the floor plan image, according to the ratio of the greatest actually-measured length corresponding to the width of the floor plan image and the greatest actually-measured length corresponding to the height of the floor plan image. That is, the data processing device 100 may regenerate the floor plan image according to the actually-measured length ratio by adjusting the greatest horizontal length, while maintaining the greatest vertical length without changes.

The data processing device 100 regenerating a floor plan image may adjust a horizontal length of the adjustable space according to a ratio of the greatest actually-measured length corresponding to the width of the floor plan image and an actually-measured length corresponding to the width of the adjustable space, and adjust a vertical length of the adjustable space according to a ratio of the greatest actually-measured length corresponding to the height of the floor plan image and an actually-measured length corresponding to the height of the adjustable space (S470).

According to an embodiment, the data processing device 100 may first adjust a ratio of the overall horizontal length of the floor plan image to the overall vertical length of the floor plan image (S460) to regenerate the plan view image, and then perform a fine adjustment with respect to the adjustable space (S470).

According to an embodiment, the data processing device 100 regenerating a floor plan image may adjust the horizontal length of the adjustable space according to the ratio of the greatest actually-measured length corresponding to the width of the floor plan image and the actually-measured length corresponding to the width of the adjustable space.

Thereafter, the data processing device 100 may adjust the vertical length of the adjustable space according to the ratio of the greatest actually-measured length corresponding to the height of the floor plan image and the actually-measured length corresponding to the height of the adjustable space.

According to an embodiment, the data processing device 100 may adjust the vertical length of the adjustable space according to the ratio of the greatest actually-measured length corresponding to the height of the floor plan image and the actually-measured length corresponding to the height of the adjustable space, and then adjust the vertical length of the adjustable space according to the ratio of the greatest actually-measured length corresponding to the width of the floor plan image and the actually-measured length corresponding to the width of the adjustable space.

The data processing device 100 regenerating a floor plan image may display an adjusted floor plan image (S480).

The data processing device 100 regenerating a floor plan image may display the adjusted floor plan image on a display.

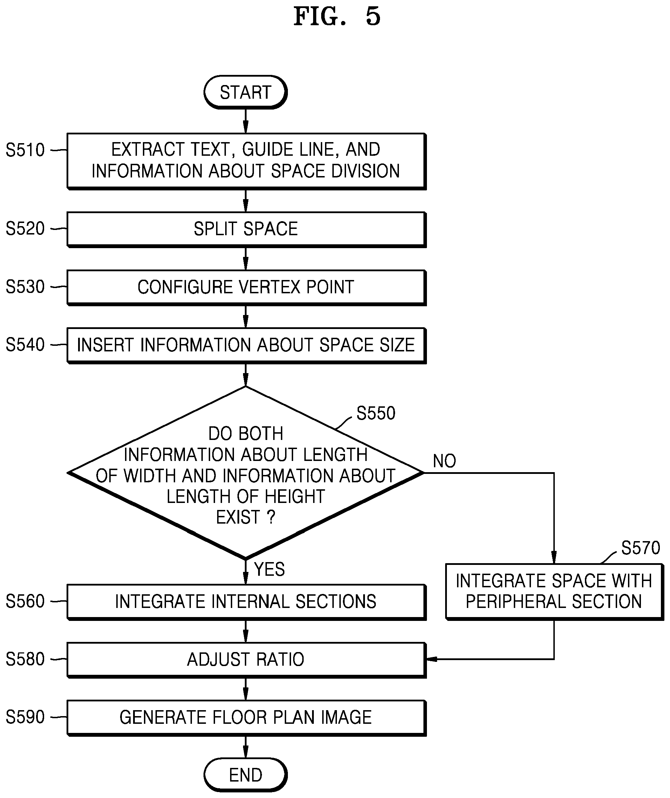

FIG. 5 is a flowchart of a data processing method of regenerating a floor plan image, according to an embodiment of the present disclosure. FIGS. 6 through 14 are diagrams for explaining, in detail, operations illustrated in FIG. 5.

The data processing method of regenerating a floor plan image, according to an embodiment of the present disclosure, will now be described using the drawings of FIGS. 6 through 14 according to the flowchart of FIG. 5.

Referring to FIG. 5, the data processing device 100 may extract text, a guideline, and information about space division from the floor plan image (S510).

An embodiment in which the data processing device 100 extracts the text and the guide line from the floor plan image is illustrated in FIG. 6.

FIG. 6 is a drawing illustrating an example in which a data processing device for regenerating a floor plan image obtains a guide line and an actually-measured length corresponding to the guide line from the floor plan image, according to an embodiment of the present disclosure.

The data processing device 100 may extract text 620 and a guide line 610 from the floor plan image.

According to an embodiment, the data processing device 100 regenerating a floor plan image may extract text from the floor plan image by using an AI model.

According to an embodiment, the data processing device 100 regenerating a floor plan image may extract text from the floor plan image through a known algorithm, such as OCR (RCNN-resnet).

The extracted text may include actually-measured length information corresponding to each guide line. According to an embodiment, the text may refer to actually-measured length information corresponding to a guide line closest in a direction from the text to a center of the floor plan image.

According to an embodiment, a portion of the obtained text may be text that is not related to the actually-measured length information corresponding to the guide line. For example, the data processing device 100 may obtain text rather than numbers. In this case, the data processing device 100 may ignore the text rather than numbers from among the obtained text.

According to an embodiment, the data processing device 100 may distinguish text corresponding to the actually-measured length information from text not corresponding to the actually-measured length information by using an AI model. According to an embodiment, the data processing device 100 may obtain only the text corresponding to the actually-measured length information corresponding to the guide line.

AI, which is a computer system that implements human-level intelligence, trains itself, and increases a recognition rate the more the AI is used. The AI includes a machine learning (deep learning) technology of using an algorithm that classifies/learns the features of pieces of input data by itself, and element technologies of mimicking functions, such as recognition and determination by human brains, by utilizing a machine learning algorithm.

For example, the element technologies may include at least one of linguistic understanding technology that recognizes human language/text, visual understanding technology that recognizes objects like human vision, deduction/prediction that logically performs deduction and prediction by determining information, knowledge representation that processes human experience information as knowledge data, vehicle's autonomous traveling, or operation control for controlling a motion of a robot.

Functions related to AI according to the disclosure are operated through the processor 110 and the memory 120. The processor 110 may be implemented as one or a plurality of processors. The one or plurality of processors may be a general-purpose processor such as a central processing unit (CPU), an application processor (AP), or a digital signal processor (DSP), a graphics-only processor such as a graphics processing unit (GPU) or a vision processing unit (VPU), or an AI-only processor such as a neural processing unit (NPU). The one or plurality of processors 110 control to process input data, according to a predefined operation rule or AI model stored in the memory 120. Alternatively, when the one or plurality of processors 110 are AI-only processors, the AI-only processors may be designed in a hardware structure specialized for processing a specific AI model.

The predefined operation rule or AI model is characterized in that it is created through learning. Here, being created through learning means that a basic AI model is trained using a plurality of training data by a learning algorithm, so that a predefined operation rule or AI model set to perform desired characteristics (or a desired purpose) is created. Such learning may be performed in the display device 100 itself on which AI according to the disclosure is performed, or may be performed through a separate server and/or system. Examples of the learning algorithm include, but are not limited to, supervised learning, unsupervised learning, semi-supervised learning, or reinforcement learning.

The AI model may be composed of a plurality of neural network layers. Each of the plurality of neural network layers has a plurality of weight values, and performs a neural network operation through an operation between an operation result of a previous layer and the plurality of weight values. The plurality of weight values of the plurality of neural network layers may be optimized by a learning result of the AI model. For example, the plurality of weight values may be updated so that a loss value or a cost value obtained from the AI model is reduced or minimized during a learning process.

In an embodiment using a deep learning algorithm, the processor 110 may determine text corresponding to actually-measured length information corresponding to the guide line from among the obtained text, by using a pre-trained deep neural network model.

The pre-trained deep neural network model may be an AI model trained through learning, the AI model using, as an input value, at least one obtained text and using, as an output value, text corresponding to the actually-measured length information corresponding to the guide line from among the input at least one text.

The deep neural network model may be, for example, a convolutional neural network (CNN) model. However, embodiments of the present disclosure are not limited thereto, and the deep neural network model may be a well-known AI model including at least one of a Recurrent Neural Network (RNN), a Restricted Boltzmann Machine (RBM), a Deep Belief Network (DBN), a Bidirectional Recurrent Deep Neural Network (BRDNN), or Deep Q-Networks.

According to an embodiment, the data processing device 100 regenerating a floor plan image may extract the guide line 610 from the floor plan image through a known algorithm, such as CV corner detection.

According to an embodiment, the data processing device 100 may identify a line corresponding to the guide line and a line not corresponding to the guide line by using an AI model.

The above-described contents of the AI model will not be repeated.

In an embodiment using a deep learning algorithm, the processor 110 may identify the line corresponding to the guide line from among the obtained lines, by using a pre-trained deep neural network model.

The pre-trained deep neural network model may be an AI model trained through learning, the AI model using, as an input value, the obtained floor plan image and using, as an output value, at least one line corresponding to the guide line from among lines identified from the floor plan image.

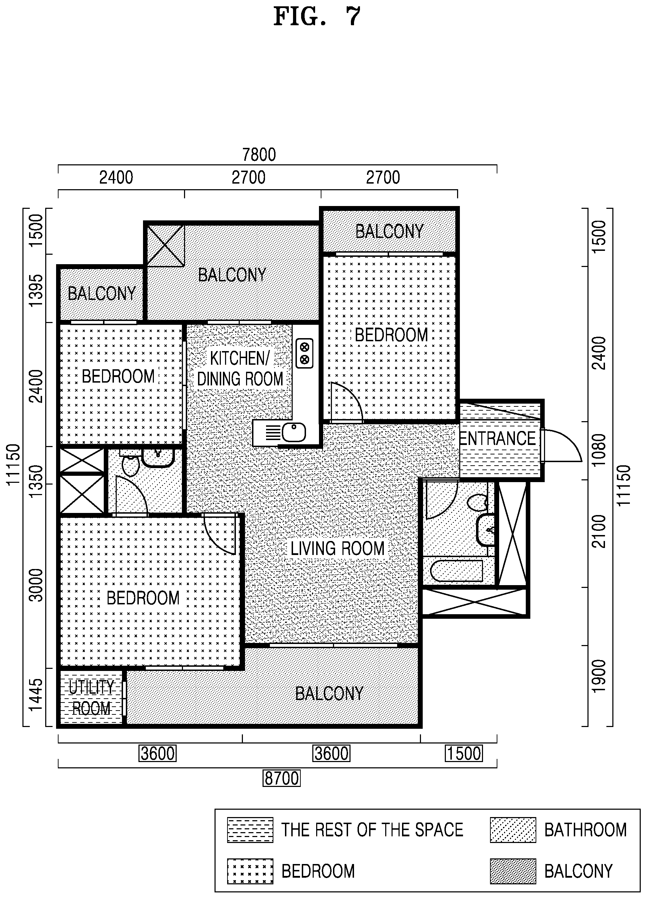

An example in which the data processing device 100 extracts information about space division from the floor plan image is illustrated in FIG. 7.

FIG. 7 is a drawing illustrating an example in which a data processing device for regenerating a floor plan image obtains information about space division from a floor plan image, according to an embodiment of the present disclosure.

According to an embodiment, the data processing device 100 regenerating a floor plan image may extract information about space division from a floor plan image according to a method using CNN-VGGBET, etc.

In the present disclosure, the "information about space division" may be information including a line representing at least one of a wall, a door, and a window, a space formed by the line, and a name of the space.

In the embodiment of FIG. 7, the data processing device 100 may obtain, from the floor plan image, each space formed by a line indicating at least one of a wall, a door, and a window, such as a bedroom, a bathroom, a balcony, or a living room, and a name of each space.

According to an embodiment, the data processing device 100 may regenerate the floor plan image by completing adjustment of the entire width and vertical lengths of the floor plan image and adjustment of width and vertical lengths of each space and then rearranging information about space division, including the line representing at least one of a wall, a door, and a window, the space formed by the line, and the name of the space, in accordance with an image resulting from these adjustments.

Referring to FIG. 5, after extracting text, a guideline, and information about space division from the floor plan image, the data processing device 100 may split a space included in the floor plan image (S520).

An embodiment in which the data processing device 100 splits the space included in the floor plan image is illustrated in FIG. 8.

FIG. 8 is a drawing illustrating an example in which a data processing device for regenerating a floor plan image splits a floor plan image into at least one section, based on a line extending from a scale of at least one guide line, according to an embodiment of the present disclosure.

According to an embodiment, the data processing device 100 may split a space on the floor plan image into detailed sections according to a scale included in a guide line.

According to an embodiment, the data processing device 100 may split the floor plan image according to lines extending from the scales of all guide lines included on the floor plan image. The data processing device 100 may extend the scale of the guide line in the same direction as a scale direction. As a result, the data processing device 100 may split the floor plan image according to all reference lines including actually-measured length information corresponding to the guide line.

According to an embodiment, the data processing device 100 regenerating a floor plan image splits the floor plan image into at least one section according to a line extending from the scale of at least one guide line, and, as a result, each space formed by a line representing at least one of a wall, a door, and a window, such as a bedroom, a bathroom, a balcony, or a living room, may be split into more detailed sections as shown in FIG. 8.

Referring to FIG. 5, after splitting a space included in the floor plan image (S520), the data processing device 100 may configure a vertex point on the floor plan image (S530).

**In** the present disclosure, the "vertex point" may refer to a point whose location is adjustable to regenerate the floor plan image. According to an embodiment, the vertex point may exist on a two dimension, and its location on the floor plan image may be expressed as a combination of X-coordinates and Y-coordinates.

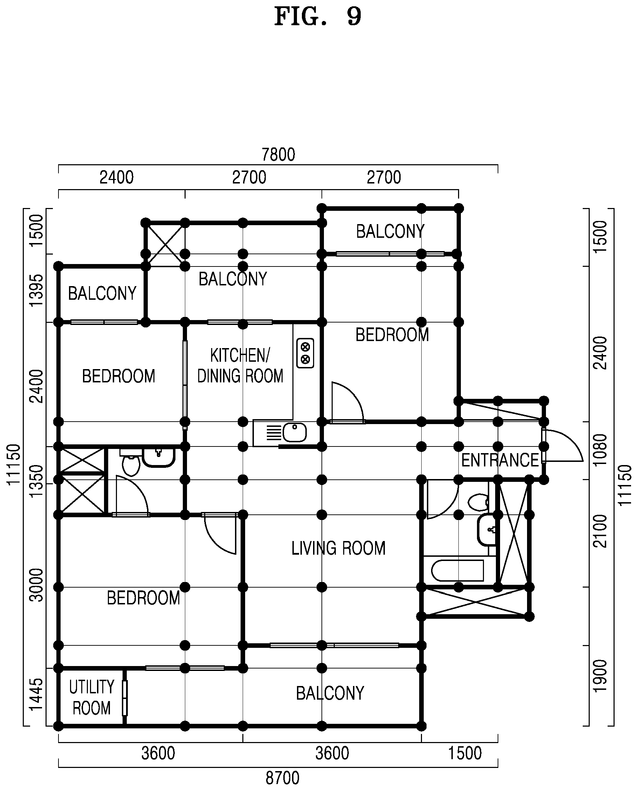

FIG. 9 is a drawing illustrating an example in which a data processing device for regenerating a floor plan image configures a vertex point and determines a section according to the vertex point, according to an embodiment of the present disclosure.

According to an embodiment, the data processing device 100 may determine, as vertex points, all locations where lines extending from the scales of all guide lines intersect each other. The data processing device 100 may determine a rectangular area including four vertex points as one section.

Referring to FIG. 5, after configuring the vertex point on the floor plan image (S530), the data processing device 100 may insert information about a space size into the floor plan image (S540).

According to an embodiment, the data processing device 100 may match the text detected in operation S510 with actually-measured length information for each corresponding guide line.

According to an embodiment, the data processing device 100 may match the text detected in operation S510 with the actually-measured length information for each corresponding guide line, and may store a result of the mapping.

According to an embodiment, the data processing device 100 may determine a guide line closest in a direction from a location of the detected text to the center of the floor plan image, as a guide line corresponding to the detected text.

According to an embodiment, the data processing device 100 may determine a guide line closest in a direction from the location of the detected text to the outside of the floor plan image, as the guide line corresponding to the detected text.

A method of determining the guide line corresponding to the detected text is not limited thereto, and various methods may be used.

According to an embodiment, the data processing device 100 may determine the guide line corresponding to the detected text according to a method determined according to a user input.

According to an embodiment, the data processing device 100 may automatically determine the guide line corresponding to the detected text according to a method set by a system.

According to an embodiment, the data processing device 100 may automatically determine the guide line corresponding to the detected text by comparing the number of guide lines on the floor plan image with the number of detected texts and comparing the location of the guide line with the location of the detected text.

According to an embodiment, the data processing device 100 does not necessarily execute an operation of injecting space size information, that is, the operation S540 of matching the detected text with the actually-measured length information for each corresponding guide line, immediately after the operation S530 of configuring the vertex point, but may freely execute, after operation S510, any operation before operation S580.

The data processing device 100 may determine whether both information about a length of a width and information about a length of a height exist for each space formed by a line representing at least one of a wall, a door, and a window (S550).

According to an embodiment, the data processing device 100 may determine whether both actually-measured length information of the width and actually-measured length information of the height exist for each space formed by the line representing at least one of a wall, a door, and a window, based on the information about space division obtained in operation S510.

When both the actually-measured length information of the width and the actually-measured length information of the height exist in a certain space, the data processing device 100 may integrate internal sections of the space (S560).

According to an embodiment, when both the actually-measured length information of the width and the actually-measured length information of the height exist in a certain space, the data processing device 100 may integrate sections existing within the space into one section by deleting all of the sections.

In this case, whether both the actually-measured length information of the width and the actually-measured length information of the height exist in a certain space may mean whether there exists actually-measured length information corresponding to one guide line.

According to an embodiment, when both the actually-measured length information of the width and the actually-measured length information of the height exist in a certain space, the data processing device 100 may integrate the sections existing within the space into one section by deleting all of the sections, and may determine the space as an adjustable space.

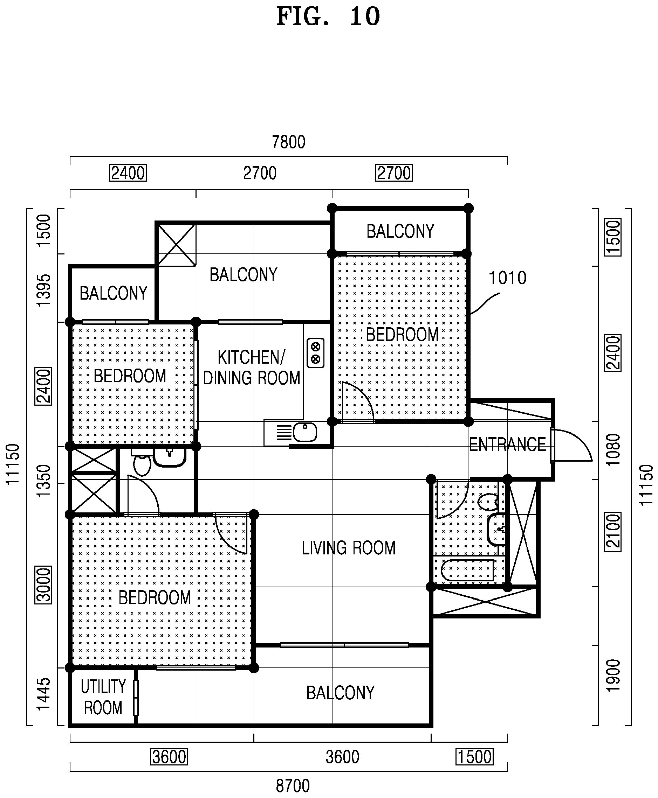

FIG. 10 is a drawing illustrating an example in which a data processing device for regenerating a floor plan image determines, as an adjustable space, a space in which both actually-measured lengths respectively corresponding to the width and the height exist, according to an embodiment of the present disclosure.

For example, a bedroom 1010 includes six sections as determined in FIG. 9, but, in the embodiment of FIG. 10, it may be seen that the bedroom 1010 is integrated as a single section in which both the actually-measured length information of the width and the actually-measured length information of the height exist.

According to the guide lines and text obtained from the floor plan image, there are guide lines respectively corresponding to an actually-measured horizontal length of 2700 and an actually-measured vertical length of 2400 of the bedroom 1010, so a section of the bedroom 1010 is a space in which both actually-measured lengths respectively corresponding to a width and a height exist.

According to an embodiment, when both actually-measured length information of the width and actually-measured length information of the height exist, the data processing device 100 may execute an operation of integrating spaces into one section, while traveling through all spaces on the floor plan image. In this case, a space may refer to a space formed by a line representing at least one of a wall, a door, and a window determined based on information about space division.

The integrated section may be determined as an adjustable space.

In the embodiment of FIG. 10, the data processing device 100 may determine an adjustable space including three bedrooms, one balcony, one bathroom, etc.

Referring to FIG. 5, when a certain space is not determined as an adjustable space in which both the actually-measured length information of the width and the actually-measured length information of the height exist, the data processing device 100 may integrate the space with a peripheral section (S570).

According to an embodiment, the data processing device 100 may integrate a remaining space not determined as the adjustable space with one of the peripheral sections around the space.

At this time, the data processing device 100 may select, as a peripheral section which is a target of integration, a peripheral section that may be an adjustable section in which both the actually-measured length information of the width of an integrated section and the actually-measured length information of the height of the integrated section exist.

In this case, whether both the actually-measured length information of the width and the actually-measured length information of the height exist in a certain section may not necessarily mean whether there exists each actually-measured length information corresponding to one guide line. That is, a case capable of ascertaining actually-measured length information of the width or height of the corresponding section by combining pieces of actually-measured length information respectively corresponding to two guide lines may be included in a case where both the actually-measured length information of the width and the actually-measured length information of the height exist.

According to an embodiment, when both the actually-measured length information of the width and the actually-measured length information of the height do not exist in a certain space, the data processing device 100 may integrate one of the peripheral sections of the space with the space to thereby change an integrated section to the adjustable space.

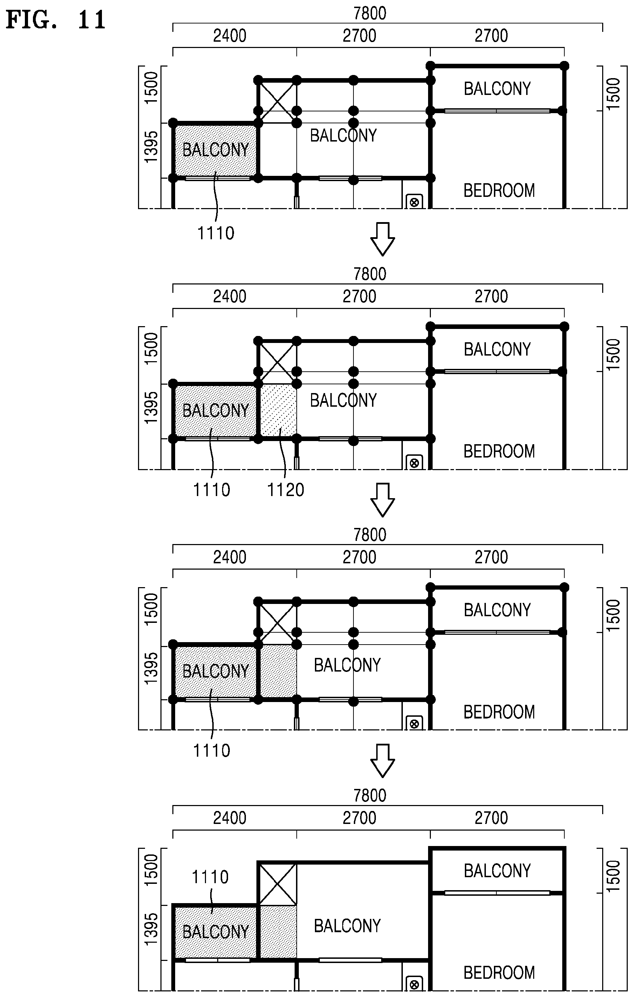

FIG. 11 is a drawing illustrating an example in which a data processing device for regenerating a floor plan image changes a combined section corresponding to a combination of peripheral sections to an adjustable space, according to an embodiment of the present disclosure.

In the embodiment of FIG. 11, the data processing device 100 may obtain that an actually-measured vertical length of a balcony 1110 within a space not determined as an adjustable space is 1395. However, because actually-measured vertical length information of a balcony 1110 does not exist on the floor plan image, the data processing device 100 may not be able to obtain actually-measured horizontal length information of the balcony 1110.

According to an embodiment, the image processing apparatus 100 may combine one peripheral section 1120 from among peripheral sections of the balcony 1110 with the section of the balcony 1110. In this case, the data processing device 100 may obtain actually-measured horizontal length information of 2400 of a combined section corresponding to a result of the combination.

The data processing device 100 may change an incomplete space having no actually-measured width information into an adjustable space where both the actually-measured vertical length information of 1395 and the actually-measured horizontal length information of 2400 exist, by integrating a space, which is the balcony 1110, with the peripheral section 1120.

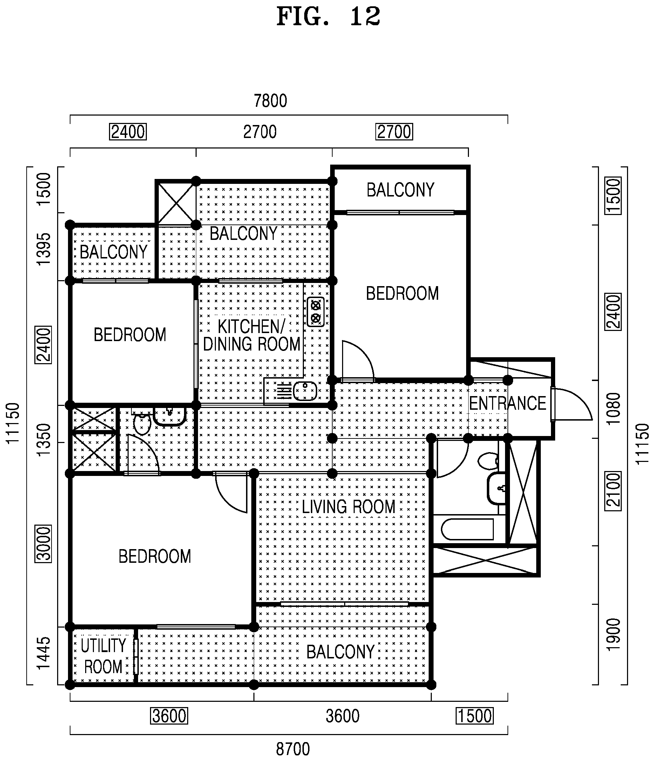

FIG. 12 is a drawing illustrating an example of a result of changing a combined section corresponding to a combination of peripheral sections to an adjustable space by a data processing device for regenerating a floor plan image, according to an embodiment of the present disclosure.

In the embodiment of FIG. 12, the data processing device 100 may change, into an adjustable space in which both actually-measured lengths respectively corresponding to a width and a height exist, a combined section obtained by combining each of the remaining spaces not determined as adjustable spaces, except for the space determined as an adjustable space in FIG. 10, with one of the peripheral sections.

Referring to FIG. 5, the data processing device 100 may adjust a ratio on the floor plan image (S580), after the operation S560 of determining the adjustable space and the operation S570 of changing a section to the adjustable space.

According to an embodiment, the data processing device 100 may adjust a greatest horizontal length or greatest vertical length of the floor plan image, according to a ratio of a greatest actually-measured length corresponding to the width of the floor plan image and a greatest actually-measured length corresponding to the height of the floor plan image.

In the present disclosure, the greatest actually-measured length corresponding to the width of the floor plan image may be actually-measured length information corresponding to a guide line indicating the entire width of the floor plan image.

In the present disclosure, the greatest actually-measured length corresponding to the height of the floor plan image may be actually-measured length information corresponding to a guide line indicating the entire height of the floor plan image.

In the present disclosure, a greatest horizontal length of the floor plan image may refer to a length of the entire width on the floor plan image. That is, the greatest horizontal length of the floor plan image may refer to a length of a greatest width guide line of the floor plan image.

In the present disclosure, a greatest vertical length of the floor plan image may refer to a length of the entire height on the floor plan image. That is, the greatest vertical length of the floor plan image may refer to a length of a greatest height guide line of the floor plan image.

That is, the data processing device 100 may adjust a length of a guide line drawn on the floor plan image in accordance with a ratio of pieces of actually-measured length information corresponding to guide lines.

According to an embodiment, the data processing device 100 may adjust a greatest vertical length of the floor plan image based on a greatest horizontal length of the floor plan image, according to the ratio of the greatest actually-measured length corresponding to the width of the floor plan image and the greatest actually-measured length corresponding to the height of the floor plan image.

According to an embodiment, the data processing device 100 may adjust a greatest horizontal length of the floor plan image based on a greatest vertical length of the floor plan image, according to the ratio of the greatest actually-measured length corresponding to the width of the floor plan image and the greatest actually-measured length corresponding to the height of the floor plan image.

According to an embodiment, the data processing device 100 may adjust an X-axis location or a Y-axis location of a vertex point included in an area indicating the entire floor plan image, according to a ratio of a greatest actually-measured length corresponding to the width of the floor plan image and a greatest actually-measured length corresponding to the height of the floor plan image.

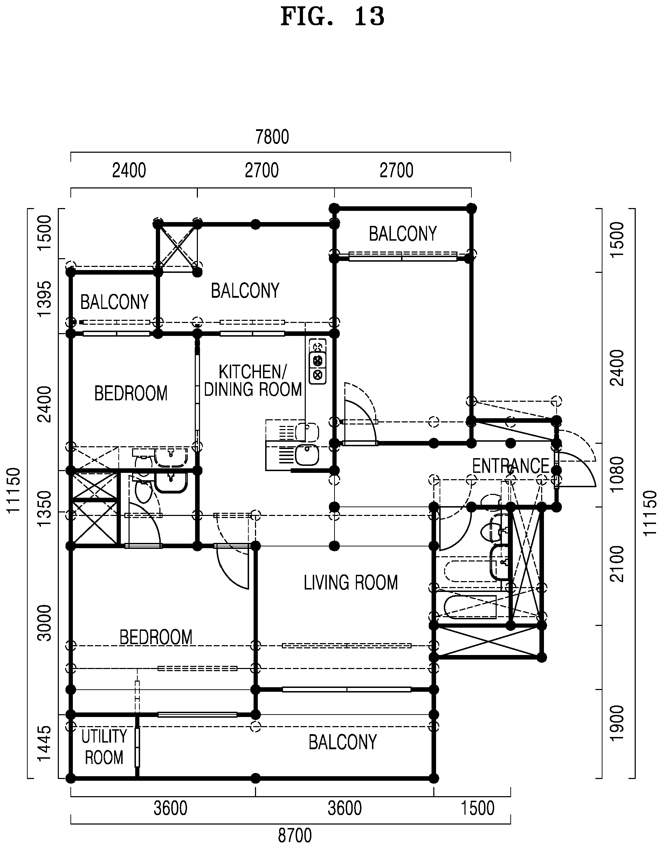

FIG. 13 is a drawing illustrating an example in which a data processing device for regenerating a floor plan image adjusts a ratio between a width and a height of the entire drawing, according to an embodiment of the present disclosure.

In the embodiment of FIG. 13, the data processing device 100 may adjust a greatest vertical length of the floor plan image based on a greatest horizontal length of the floor plan image, according to a ratio 7800:11150 of a greatest actually-measured length of 7800 corresponding to the width of the floor plan image and a greatest actually-measured length of 11150 corresponding to the height of the floor plan image.

In the embodiment of FIG. 13, the data processing device 100 may expand the greatest vertical length downwards, according to the ratio 7800:11150 of the greatest actually-measured length of 7800 corresponding to the width of the floor plan image and the greatest actually-measured length of 11150 corresponding to the height of the floor plan image.

In the embodiment of FIG. 13, the ratio of the greatest actually-measured length of 7800 corresponding to the width of the floor plan image and the greatest actually-measured length of 11150 corresponding to the height of the floor plan image may be approximately 1:1.28. However, an actual floor plan image may be drawn at a ratio of 1:1.176.

In this case, in order to address an error in which a horizontal length and a vertical length on the floor plan image is drawn at a scale of 1:1.176 even when the ratio of the greatest actually-measured length of 7800 corresponding to the width of the floor plan image and the greatest actually-measured length of 11150 corresponding to the height of the floor plan image is 1:1.28, the data processing device 100 may expand downwards by a ratio of 0.104 of the greatest vertical length of the floor plan image based on the greatest horizontal length of the floor plan image.

According to an embodiment, the data processing device 100 may adjust the greatest vertical length of the floor plan image by adjusting the Y-axis location of the vertex point included in an area indicating the entire floor plan image.

According to an embodiment, the data processing device 100 may adjust the lengths of the entire width and entire height, and then adjust the lengths of a width and a height of each adjustable space in accordance with the adjusted width and vertical lengths.

According to an embodiment, the data processing device 100 may adjust the horizontal length of the adjustable space according to the ratio of the greatest actually-measured length corresponding to the width of the floor plan image and the actually-measured length corresponding to the width of the adjustable space.

According to an embodiment, the data processing device 100 may adjust the vertical length of the adjustable space according to the ratio of the greatest actually-measured length corresponding to the height of the floor plan image and the actually-measured length corresponding to the height of the adjustable space.

According to an embodiment, the data processing device 100 may adjust an X-axis location of a vertex point included in the adjustable space, according to a ratio of the greatest actually-measured length corresponding to the width of the floor plan image and an actually-measured length corresponding to a width of the adjustable space.

According to an embodiment, the data processing device 100 may adjust an X-axis location of a vertex point included in the adjustable space, according to a ratio of the greatest actually-measured length corresponding to the height of the floor plan image and an actually-measured length corresponding to a height of the adjustable space.

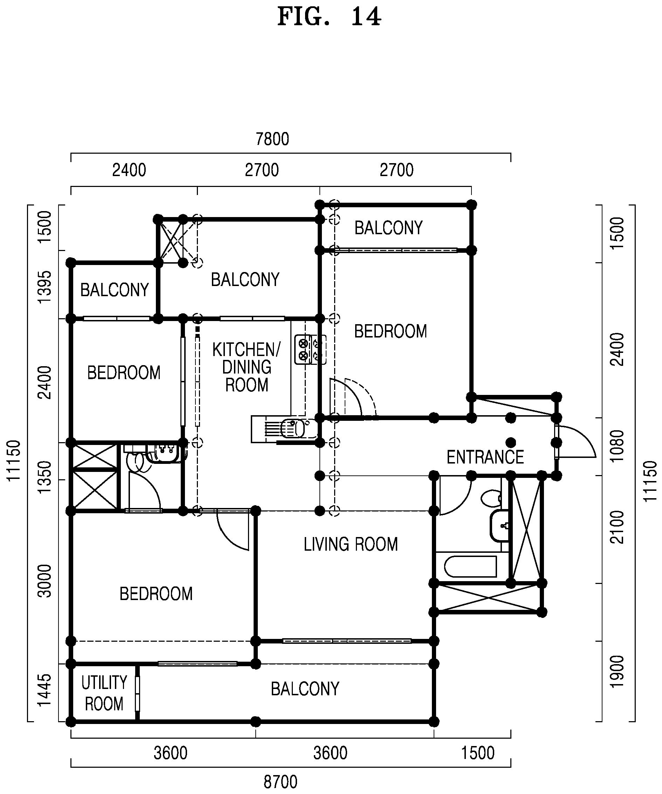

FIG. 14 is a drawing illustrating an example in which a data processing device for regenerating a floor plan image adjusts a ratio between a width and a height of each adjustable space, according to an embodiment of the present disclosure.

The data processing device 100 may adjust the lengths of the entire width and entire height, and then adjust the lengths of a width and a height of each adjustable space in accordance with the adjusted width and vertical lengths.

The floor plan image shown in the embodiment of FIG. 14 may be a floor plan image after the lengths of the entire width and the entire height are first adjusted.

In the embodiment of FIG. 14, the data processing device 100 may adjust the horizontal length of each adjustable space according to the ratio of the greatest actually-measured length of 7800 corresponding to the width of the floor plan image and the actually-measured length corresponding to the width of each adjustable space.

In the embodiment of FIG. 14, the data processing device 100 may adjust a horizontal length of a first adjustable space according to a ratio of the greatest actually-measured length of 7800 corresponding to the width of the floor plan image and an actually-measured length of 2400 corresponding to a width of the first adjustable space.

In the embodiment of FIG. 14, the data processing device 100 may adjust a horizontal length of a second adjustable space according to a ratio of the greatest actually-measured length of 7800 corresponding to the width of the floor plan image and an actually-measured length of 2700 corresponding to a width of the second adjustable space.

In the embodiment of FIG. 14, the data processing device 100 may adjust a horizontal length of a third adjustable space according to a ratio of the greatest actually-measured length of 7800 corresponding to the width of the floor plan image and an actually-measured length of 2700 corresponding to a width of the third adjustable space.

In the embodiment of FIG. 14, the lengths of 2400, 2700, and 2700 of the width of each adjustable space may have a ratio of approximately 1: 1.125: 1.125 with respect to the greatest actually-measured length of 7800 corresponding to the width of the floor plan image. However, the floor plan image may be drawn at a ratio of 1: 1.06: 1.06.

In this case, the data processing device 100 may maintain the greatest horizontal length of the floor plan image without changes, reduce the horizontal length of the first adjustable space, and expand the respective horizontal lengths of the second adjustable space and the third adjustable space in a left direction.

According to an embodiment, the data processing device 100 may adjust an X-axis location of a vertex point included in the adjustable space, according to a ratio of the greatest actually-measured length corresponding to the width of the floor plan image and an actually-measured length corresponding to a width of the adjustable space.

The data processing device 100 may adjust the vertical length of each adjustable space according to the ratio of the greatest actually-measured length corresponding to the height of the floor plan image and the actually-measured length corresponding to the height of each adjustable space.

Referring to FIG. 5, the data processing device 100 may regenerate the floor plan image (S590).

The data processing device 100 may regenerate the floor plan image by reflecting a result of the ratio adjustment in operation S580.

According to an embodiment, the data processing device 100 may rearrange a guide line and an actually-measured length corresponding to the guide line from a result of the adjustment. The data processing device 100 may adjust a location and a length of the guide line to correspond to an adjusted length. The data processing device 100 may adjust a location of a scale of the guide line to correspond to the adjusted length. The data processing device 100 may adjust an arrangement of an actually-measured length corresponding to each guide line according to the location and length of the adjusted guide line.

According to an embodiment, the data processing device 100 may rearrange information about space division according to a result of the adjustment. The data processing device 100 may obtain a line indicating at least one of a wall, a door, and a window and a name of a space formed by the line, in accordance with the location of a vertex point moved according to the result of the adjustment.

A computer-readable recording medium according to an embodiment may be a computer-readable recording medium having recorded thereon a program for implementing an operation method of a computing device, the operation method including determining whether at least one character exists on a playback screen of content by using a character recognition model, and, when it is determined that the at least one character exists on the playback screen of the content, recognizing a character string including the at least one character to obtain a first character string. The computer-readable recording medium according to an embodiment may be a computer-readable recording medium having recorded thereon a program for implementing an operation method of a computing device, the operation method including determining whether a sound exists in audio data included in a playback section including the at least one character by using a voice recognition model, and, when it is determined that the sound exists in the audio data, recognizing the sound and converting the recognized sound into a character string to obtain a second character string. The computer-readable recording medium according to an embodiment may be a computer-readable recording medium having recorded thereon a program for implementing an operation method of a computing device, the operation method including updating the character recognition model, based on a mismatched portion between the first character string and the second character string, by comparing the first character string with the second character string.

According to an embodiment, a method according to various disclosed embodiments may be provided by being included in a computer program product. The computer program product, which is a commodity, may be traded between sellers and buyers. Computer program products are distributed in the form of device-readable storage media (e.g., compact disc read only memory (CD-ROM)), or may be distributed (e.g., downloaded or uploaded) through an application store or between two user devices (e.g., smartphones) directly and online. **In** the case of online distribution, at least a portion of the computer program product (e.g., a downloadable app) may be stored at least temporarily in a device-readable storage medium, such as a memory of a manufacturer's server, a server of an application store, or a relay server, or may be temporarily generated.

A data processing method of regenerating a floor plan image, according to an embodiment, includes an operation of obtaining a floor plan image, an operation of obtaining, from the obtained floor plan image, at least one guide line and an actually-measured length corresponding to each of the at least one guide line, an operation of splitting the floor plan image into at least one section, based on a line extending from a scale of the at least one guide line, an operation of determining, as an adjustable space, a section in which both actually-measured lengths respectively corresponding to a width and a height exist, among the at least one section, an operation of changing, into the adjustable space in which both the actually-measured lengths respectively corresponding to the width and the height exist, a combined section obtained by combining each of the remaining spaces not determined as adjustable spaces, among the at least one section, with one of the peripheral sections, an operation of adjusting a ratio of a greatest horizontal length and a greatest vertical length of the floor plan image, according to a ratio of a greatest actually-measured length corresponding to a width of the floor plan image and a greatest actually-measured length corresponding to a height of the floor plan image, an operation of adjusting a horizontal length of the adjustable space according to a ratio of the greatest actually-measured length corresponding to the width of the floor plan image and an actually-measured length corresponding to a width of the adjustable space, and an operation of adjusting a vertical length of the adjustable space according to a ratio of the greatest actually-measured length corresponding to the height of the floor plan image and the actually-measured length corresponding to the height of the adjustable space.

The operation of adjusting the ratio of the greatest horizontal length and the greatest vertical length of the floor plan image may include adjusting the greatest vertical length of the floor plan image based on the greatest horizontal length of the floor plan image, according to the ratio of the greatest actually-measured length corresponding to the width of the floor plan image and the greatest actually-measured length corresponding to the height of the floor plan image.

The operation of splitting may include determining, as a vertex point, a location where lines respectively extending from the scales of the at least one guide line intersect each other, and determining a rectangular area including four vertex points as one section.

The operation of adjusting may include adjusting the ratio of the greatest horizontal length and the greatest vertical length of the floor plan image, by adjusting an X-axis location or a Y-axis location of a vertex point included in an area indicating the entirety of the floor plan image according to the ratio of the greatest actually-measured length corresponding to the width of the floor plan image and the greatest actually-measured length corresponding to the height of the floor plan image.

The operation of adjusting may include adjusting a horizontal length of the adjustable space by adjusting an X-axis location of a vertex point included in the adjustable space according to a ratio of the greatest actually-measured length corresponding to the width of the floor plan image and the actually-measured length corresponding to the width of the adjustable space.

The operation of adjusting may include adjusting a vertical length of the adjustable space by adjusting a Y-axis location of a vertex point included in the adjustable space according to a ratio of the greatest actually-measured length corresponding to the height of the floor plan image and the actually-measured length corresponding to the height of the adjustable space.

The data processing method of regenerating the floor plan image may further include obtaining information about space division, including a line representing at least one of a wall, a door, and a window and a name of a space formed by the line, from the obtained floor plan image, and rearranging the information about the space division according to a result of the adjusting.

The actually-measured length corresponding to the at least one guide line may be obtained by detecting text information corresponding to the at least one guide line from the floor plan image and matching the detected text information with the actually-measured length corresponding to the at least one guide line.

The data processing method of regenerating the floor plan image may further include rearranging the guide line and the actually-measured length corresponding to the guide line according to the result of the adjusting.

The data processing method of regenerating the floor plan image may further include rearranging the floor plan image by reflecting the result of the adjusting.

According to an embodiment, a data processing device for regenerating a floor plan image may include a memory storing one or more instructions, and at least one processor configured to execute the one or more instructions stored in the memory, wherein the at least one processor may be configured to execute the one or more instructions to obtain a floor plan image, obtain, from the obtained floor plan image, at least one guide line and an actually-measured length corresponding to each of the at least one guide line, split the floor plan image into at least one section, based on a line extending from a boundary of the at least one guide line, determine, as an adjustable space, a section in which both actually-measured lengths respectively corresponding to a width and a height exist, among the at least one section, change, into the adjustable space in which both the actually-measured lengths respectively corresponding to the width and the height exist, a combined section obtained by combining each of the remaining spaces not determined as adjustable spaces, among the at least one section, with one of the peripheral sections, adjust a ratio of a greatest horizontal length and a greatest vertical length of the floor plan image, according to a ratio of a greatest actually-measured length corresponding to a width of the floor plan image and a greatest actually-measured length corresponding to a height of the floor plan image, adjust a horizontal length of the adjustable space according to a ratio of the greatest actually-measured length corresponding to the width of the floor plan image and an actually-measured length corresponding to a width of the adjustable space, and adjust a vertical length of the adjustable space according to a ratio of the greatest actually-measured length corresponding to the height of the floor plan image and the actually-measured length corresponding to the height of the adjustable space.

The at least one processor may be configured to execute the one or more instructions to adjust an overall vertical length of the floor plan image based on an overall horizontal length of the floor plan image, according to a ratio of an actually-measured length corresponding to the entire width of the floor plan image and an actually-measured length corresponding to the entire height of the floor plan image.

The at least one processor may be configured to execute the one or more instructions to determine, as a vertex point, a location where lines respectively extending from boundaries of the at least one guide line intersect each other, and determine a rectangular area including four vertex points as one section.

The at least one processor may be configured to execute the one or more instructions to adjust the ratio of the greatest horizontal length and the greatest vertical length of the floor plan image, by adjusting an X-axis location or a Y-axis location of a vertex point included in an area indicating the entirety of the floor plan image according to the ratio of the greatest actually-measured length corresponding to the width of the floor plan image and the greatest actually-measured length corresponding to the height of the floor plan image.

The at least one processor may be configured to execute the one or more instructions to adjust a horizontal length of the adjustable space by adjusting an X-axis location of a vertex point included in the adjustable space according to a ratio of the greatest actually-measured length corresponding to the width of the floor plan image and the actually-measured length corresponding to the width of the adjustable space.

The at least one processor may be configured to execute the one or more instructions to adjust a vertical length of the adjustable space by adjusting a Y-axis location of a vertex point included in the adjustable space according to a ratio of the greatest actually-measured length corresponding to the height of the floor plan image and the actually-measured length corresponding to the height of the adjustable space.

The at least one processor may be configured to execute the one or more instructions to obtain information about space division, including a line representing at least one of a wall, a door, and a window and a name of a space formed by the line, from the obtained floor plan image, and rearrange the information about the space division according to a result of the adjustment.

The actually-measured length corresponding to the at least one guide line may be obtained by detecting text information corresponding to the at least one guide line from the floor plan image and matching the detected text information with the actually-measured length corresponding to the at least one guide line.

The at least one processor may be configured to execute the one or more instructions to rearrange the guide line and the actually-measured length corresponding to the guide line from the result of the adjustment.

A computer-readable recording medium according to an embodiment may be a recording medium having recorded thereon a program for implementing a data processing method of regenerating a floor plan image, the data processing method including an operation of obtaining a floor plan image, an operation of obtaining, from the obtained floor plan image, at least one guide line and an actually-measured length corresponding to each of the at least one guide line, an operation of splitting the floor plan image into at least one section, based on a line extending from a scale of the at least one guide line, an operation of determining, as an adjustable space, a section in which both actually-measured lengths respectively corresponding to a width and a height exist, among the at least one section, an operation of changing, into the adjustable space in which both the actually-measured lengths respectively corresponding to the width and the height exist, a combined section obtained by combining each of the remaining spaces not determined as adjustable spaces, among the at least one section, with one of the peripheral sections, an operation of adjusting a ratio of a greatest horizontal length and a greatest vertical length of the floor plan image, according to a ratio of a greatest actually-measured length corresponding to a width of the floor plan image and a greatest actually-measured length corresponding to a height of the floor plan image, an operation of adjusting a horizontal length of the adjustable space according to a ratio of the greatest actually-measured length corresponding to the width of the floor plan image and an actually-measured length corresponding to a width of the adjustable space, and an operation of adjusting a vertical length of the adjustable space according to a ratio of the greatest actually-measured length corresponding to the height of the floor plan image and the actually-measured length corresponding to the height of the adjustable space.

According to an embodiment, methods according to various disclosed embodiments may be provided by being included in a computer program product. The computer program product, which is a commodity, may be traded between sellers and buyers. Computer program products are distributed in the form of device-readable storage media (e.g., compact disc read only memory (CD-ROM)), or may be distributed (e.g., downloaded or uploaded) through an application store or between two user devices (e.g., smartphones) directly and online. In the case of online distribution, at least a portion of the computer program product (e.g., a downloadable app) may be stored at least temporarily in a device-readable storage medium, such as a memory of a manufacturer's server, a server of an application store, or a relay server, or may be temporarily generated.

## Claims

1. A data processing method, performed by a data processing device (100), of regenerating a floor plan image, the data processing method comprising:
obtaining a floor plan image (101);
obtaining, from the obtained floor plan image (101), at least one guide line (202, 203, 610) including a scale (201) and an actually-measured length (205, 620) corresponding to each of the at least one guide line;
splitting the floor plan image (101) into at least one section, based on a line extending from the scale (201);
determining, as an adjustable space, a section in which both actually-measured lengths respectively corresponding to a width and a height exist, among the at least one section;
adjusting a ratio of a greatest horizontal length and a greatest vertical length of the floor plan image, according to a ratio of a greatest actually-measured length corresponding to a width of the floor plan image and a greatest actually-measured length corresponding to a height of the floor plan image;
adjusting a horizontal length of the adjustable space according to a ratio of the greatest actually-measured length corresponding to the width of the floor plan image and an actually-measured length corresponding to a width of the adjustable space, and adjusting a vertical length of the adjustable space according to a ratio of the greatest actually-measured length corresponding to the height of the floor plan image and the actually-measured length corresponding to the height of the adjustable space; and
displaying the adjusted floor plan image (102).

2. The data processing method of claim 1, wherein the adjusting of the ratio of the greatest horizontal length and the greatest vertical length of the floor plan image comprises
adjusting the greatest vertical length of the floor plan image based on the greatest horizontal length of the floor plan image, according to the ratio of the greatest actually-measured length corresponding to the width of the floor plan image and the greatest actually-measured length corresponding to the height of the floor plan image.

3. The data processing method of any one of claims 1 and 2, wherein the splitting comprises
determining, as a vertex point, a location where lines respectively extending from the scales (201) of the at least one guide line intersect each other, and determining a rectangular area including four vertex points as one section.

4. The data processing method of claim 3, wherein the adjusting comprises
adjusting the ratio of the greatest horizontal length and the greatest vertical length of the floor plan image (101), by adjusting an X-axis location or a Y-axis location of a vertex point included in an area indicating the entirety of the floor plan image (101) according to the ratio of the greatest actually-measured length corresponding to the width of the floor plan image (101) and the greatest actually-measured length corresponding to the height of the floor plan image (101).

5. The data processing method of any one of claims 3 and 4, wherein the adjusting comprises
adjusting a horizontal length of the adjustable space by adjusting an X-axis location of a vertex point included in the adjustable space according to a ratio of the greatest actually-measured length corresponding to the width of the floor plan image (101) and the actually-measured length corresponding to the width of the adjustable space (1010).

6. The data processing method of any one of claims 3 through 5, wherein the adjusting comprises
adjusting a vertical length of the adjustable space (1010) by adjusting a Y-axis location of a vertex point included in the adjustable space (1010) according to a ratio of the greatest actually-measured length corresponding to the height of the floor plan image (101) and the actually-measured length corresponding to the height of the adjustable space (1010).

7. The method of any one of claims 1 through 6, further comprising:
obtaining, from the obtained floor plan image (101), information about space division, including a line representing at least one of a wall, a door, and a window and a name of a space formed by the line; and
rearranging the information about the space division according to a result of the adjusting.

8. The method of any one of claims 1 through 7, wherein the actually-measured length corresponding to the at least one guide line is obtained by detecting text information corresponding to the at least one guide line (610) from the floor plan image and matching the detected text information with the actually-measured length corresponding to the at least one guide line.

9. The method of any one of claims 1 through 8, further comprising
rearranging the at least one guide line (610) and the actually-measured length corresponding to the at least one guide line (610) according to the result of the adjusting.

10. The method of any one of claims 1 through 9, further comprising
rearranging the floor plan image by reflecting the result of the adjusting.

11. A data processing device comprising:
a memory (120) storing one or more instructions; and
at least one processor (110) configured to execute the one or more instructions stored in the memory (120), wherein the at least one processor (110) is configured to execute the one or more instructions to:
obtain a floor plan image (101);
obtain, from the obtained floor plan image (101), at least one guide line (202, 203, 610) including a scale (201) and an actually-measured length (205, 620) corresponding to each of the at least one guide line;
split the floor plan image into at least one section, based on a line extending from the scale (201);
determine, as an adjustable space, a section in which both actually-measured lengths respectively corresponding to a width and a height exist, among the at least one section;
adjust a ratio of a greatest horizontal length and a greatest vertical length of the floor plan image (101), according to a ratio of a greatest actually-measured length corresponding to a width of the floor plan image (101) and a greatest actually-measured length corresponding to a height of the floor plan image (101);
adjust a horizontal length of the adjustable space according to a ratio of the greatest actually-measured length corresponding to the width of the floor plan image (101) and an actually-measured length corresponding to a width of the adjustable space, adjust a vertical length of the adjustable space according to a ratio of the greatest actually-measured length corresponding to the height of the floor plan image (101) and the actually-measured length corresponding to the height of the adjustable space, and display the adjusted floor plan image.

12. The data processing device of claim 11, wherein the at least one processor (110) is configured to execute the one or more instructions to
adjust an overall vertical length of the floor plan image based on an overall horizontal length of the floor plan image, according to a ratio of an actually-measured length corresponding to the entire width of the floor plan image and an actually-measured length corresponding to the entire height of the floor plan image.

13. The data processing device of any one of claims 11 and 12, wherein the at least one processor (110) is configured to execute the one or more instructions to determine, as a vertex point, a location where lines respectively extending from boundaries of the at least one guide line intersect each other, and determine a rectangular area including four vertex points as one section.

14. The data processing device of claim 13, wherein the at least one processor (110) is configured to execute the one or more instructions to
adjust the ratio of the greatest horizontal length and the greatest vertical length of the floor plan image, by adjusting an X-axis location or a Y-axis location of a vertex point included in an area indicating the entirety of the floor plan image according to the ratio of the greatest actually-measured length corresponding to the width of the floor plan image and the greatest actually-measured length corresponding to the height of the floor plan image.

15. A computer-readable recording medium having recorded thereon a program, which, when executed by a computer, performs the method of any one of claims 1 through 10.
